# EUROPEAN PATENT APPLICATION

(11) **EP 3 406 962 A1**
(43) Date of publication of application: **28.11.2018**
(21) Application number: 18172101.0
(22) Date of filing: 14.05.2018
(51) Int. Cl.: F21K 9/90, F21Y 105/10, F21Y 105/16, F21Y 115/10

(54) **A LIGHTING DEVICE AND CORRESPONDING METHOD**

(30) Priority: 24.05.2017 IT 201700056197
(71) Applicant: OSRAM GmbH, 80807 München (DE); OSRAM S.P.A. - SOCIETA' RIUNITE OSRAM EDISON CLERICI, 20126 Milano (IT)
(72) Inventor: VENK, Sridharan, I-31100 Treviso (IT)
(74) Representative: Bosotti, Luciano

(57) **Abstract**

A lighting device (10) includes a stack up of layers, including:
- a light-emitting layer (100) with a distribution of electrically-powered light radiation sources (100a), and
- at least one light-diffusive layer (106a, 106b) laminated over the light-emitting layer (100) to diffuse light radiation from the light radiation sources (100a).

## Description

### Technical field

The description relates to lighting devices.

One or more embodiments may relate to lighting devices using electrically-powered light radiation sources, such as solid-state light radiation sources e.g. LED sources.

### Technological background

Various conventional lighting devices e.g. using LEDs include laminated glass and plastics adapted for various applications such as glazing, door, walls, windows and paneling applications.

These devices may include LEDs assembled directly or indirectly on a glass or plastic substrate.

Various conventional arrangements may suffer from undesired glare and/or presence of bright spots.

Such drawbacks have been addressed in various ways, e.g. by:
- concealing LEDs at the edges,
- using light guides,
- coating enamel on the surface to reduce light intensity,
- designing optical structures on plastic or glass surfaces,
- various combinations of the foregoing.

In certain instances (e.g. optical structures patterned on glass), the manufacturing process may be fairly expensive and present limitations in terms of features which can be realized.

In addition to possible issues related to cost, various approaches as discussed in the foregoing may end up by providing essentially "fixed" solutions, namely solutions where light management is permanently defined e.g. by light guide design, an enamel layer on the top surface of glass or plastic substrates or the type of diffusive elements in an adhesive layer.

### Object and summary

An object of one or more embodiments is to contribute in addressing the various issues discussed in the foregoing.

According to one or more embodiments, such an object can be achieved by means of a lighting device having the features set forth in the claims that follow.

One or more embodiments may relate to a corresponding method.

The claims are an integral part of the technical disclosure of embodiments as provided herein.

One or more embodiments may provide a simple and low-cost solution making it possible to use existing and customizable diffuser layers, including e.g. polyethylene terephthalate - PET, polycarbonate - PC or other plastics materials as already available on the market.

One or more embodiments may involve using a laminating process of e.g. diffuser layers as a part of a stacked layer arrangement ("stack up").

### Brief description of the figures

One or more embodiments will now be described, by way of example only, with reference to the annexed figures, wherein:
- Figure 1 is exemplary of a lighting device according to embodiments illustrated in an exploded view; and
- Figure 2 is a schematic representation of a process which may be used in embodiments.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

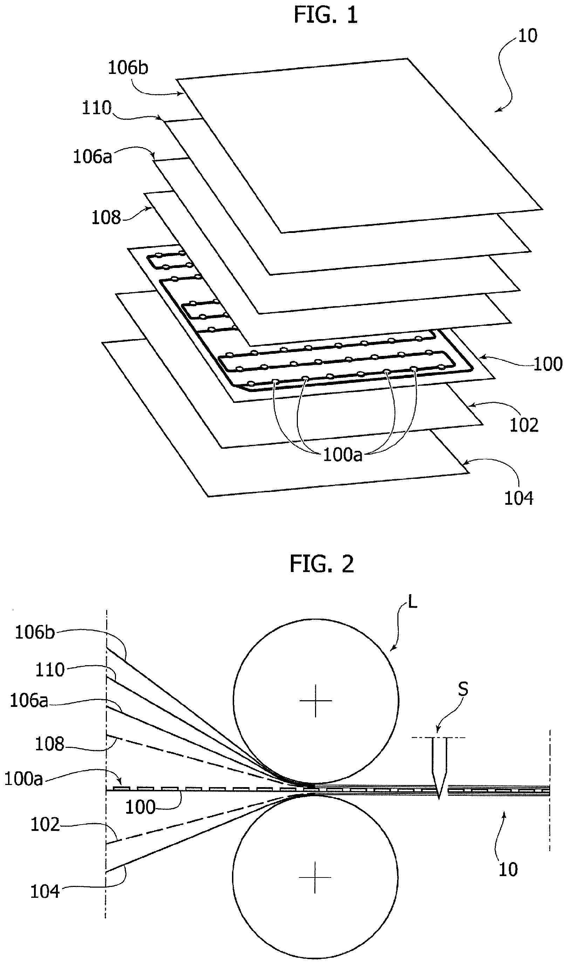

Figure 1 is an exploded view of a lighting device 10 including electrically-powered light radiation sources. Solid-state light radiation sources such as LED sources may be exemplary of such light radiation sources.

The exploded view of Figure 1 illustrates a stacked arrangement ("stack up") of layers included in the device 10.

A device 10 as exemplified in Figure 1 may be in the form of an (e.g. flexible) panel adapted for so-called "area lighting" applications. In one or more embodiments, the device 10 may include an elongated, ribbon-like element.

It will be otherwise understood that the stacked arrangement as exmeplified herein lends itself to being imparted any shape in a wide variety of possible choices (quadrilateral, round, elliptical, mistilinear, and so on).

For instance, a device 10 as exemplified herein may be used in glazing/window applications, e.g. in buildings or in the automotive sector. A device 10 as exemplified herein also lends itself to being produced with a shape corresponding to the shape of e.g. symbols such as letters or numbers, thus making the device 10 adapted for signaling applications.

In one or more embodiment, the stacked arrangement of layers of the lighting device 10 may include a light-emitting layer 100 with a distribution of electrically-powered light radiation sources 100a (e.g. LEDs) with associated electrically-conductive formations ("traces") serving the radiation sources 100a for power supply and, possibly, control purposes.

The light-emitting layer 100 may include a (possibly flexible) substrate (such as a Printed Circuit Board - PCB) including e.g. light-permeable (e.g. transparent) or light-impermeable material.

Such a light-emitting layers may be produced in various ways according to known processes, thus making it unnecessary to provide a more detailed description herein.

A (very) thin, flexible light emitting arrangement suited for use in one or more embodiments is disclosed in a co-pending patent application filed on even date in the name of the same Applicants.

In one or more embodiments, the light-emitting layer 100 may be coupled, e.g. via an adhesive layer 102, to a support substrate 104 including e.g. glass or plastic material.

In one or more embodiments, one or more light-diffusive layer, such as two diffuser layers 106a, 106b may be coupled to (e.g. laminated over) the light-emitting layer 100 with the capability of diffusing light radiation from the light radiation sources 100a.

In one or more embodiments, coupling (e.g. laminating) the one or more light-diffusive layers 106a, 106b over the light-emitting layer 10 may include an adhesive layer 108 of a material like or different from the material included in the adhesive layer 102.

Materials adapted for use for the adhesive layers such as 102 and 108 include e.g. polyvinyl butyral - PVB.

In one or more embodiments, a layer 110 including e.g. glass or plastic material may be provided onto the light-diffusive layer 106a e.g. to act as a protective front layer for the device 10 with the light-diffusive layer 106a sandwiched between the light emitting layer 100 and the layer 110.

In those embodiments as exemplified herein where not just one light-diffusive layer 106a, but plural light-diffusive layer 106a, 106b are provided, the layer 110 may act as a separation layer in turn sandwiched between the light-diffusive layers 106a, 106b.

In one or more embodiments the one or more light-diffusive layers (e.g. 106a, 106b) may include light-diffusive material plastics materials.

Polyethylene terephthalate - PET or polycarbonate - PC are exemplary of materials adapted for producing such light-diffusive layers.

One or more embodiments as exemplified herein lend themselves to producing lighting devices in the form of flexible panels including a stacked arrangement of layers ("stack up") produced e.g. by lamination.

Lamination may involve using adhesive layers (e.g. PVB) which can be treated at high temperature and pressure to facilitate bonding of the various layers in the stacked arrangement.

One or more embodiments may adopt various combinations of diffusive structures.

For instance, a certain application may involve using a diffuser layer reducing light spots and providing a uniform lit appearance. In other applications, diffuser layers may be adopted in order to reduce glare. One or more embodiments may adopt a combination of the two. In one or more embodiments light management may thus take place within a stacked arrangement of layers.

One or more embodiments are applicable to both direct and indirect mounting of light radiation sources such as LEDs on a substrate.

Embodiments as exemplified herein may include at least one light-diffusive layer (e.g. 106a, 106b) arranged on one side of the light-emitting layer 100 with light radiation from the layer 100 intended to be diffused primarily towards a semi-space (e.g. the one opposite the substrate 104).

In one or more embodiments (e.g. embodiments using a light-permeable substrate for mounting the light radiation sources 100a in the light-emitting layer 100) light radiation may propagate on both sides of the light-emitting layer 100, so that light-diffusive layers as disclosed herein may be provided on both sides of the light-emitting layer 100.

Figure 2 is schematically exemplary of a lighting device 10 as discussed herein being produced by laminating together at a lamination station L the various layers included in the stacked arrangement. The representation of Figure 2 is deliberately schematic and thus represents a single lamination step while in fact lamination may occur in subsequent steps (acts) at cascaded lamination stations according to principles known in the art.

Figure 2 is also schematically exemplary of the possibility of producing a device 10 as discussed herein as a (notionally) endless web which can be cut to length, e.g. at S, according to the intended application. The cutting act S in Figure 2 is generally exemplary of the possibility of imparting to the stacked arrangement of the device a shape selected in wide variety of different options as discussed previously.

In one or more embodiments, a lighting device (e.g. 10) including a stacked arrangement of layers, the arrangement including:
- a light-emitting layer (e.g. 100) with a distribution of electrically-powered light radiation sources (e.g. 100a), and
- at least one light-diffusive layer (e.g. 106a, 106b) laminated over the light-emitting layer to diffuse light radiation from the light radiation sources.

One or more embodiments may include a light-permeable adhesive layer (e.g. 108) between the light-emitting layer and the at least one light-diffusive layer.

One or more embodiments may include a light-permeable cover layer (e.g. 110) with the at least one light-diffusive layer sandwiched between the light-emitting layer and the light-permeable cover layer.

One or more embodiments may include a plurality of light-diffusive layers laminated over the light-emitting layer to diffuse light radiation from the light radiation sources.

One or more embodiments may include a cover layer sandwiched between two light-diffusive layers in the plurality of light-diffusive layers.

One or more embodiments may include a support substrate (e.g. 104) coupled to the light-emitting layer.

One or more embodiments may include a support substrate coupled to the light-emitting layer opposite the at least one light-diffusive layer.

In one or more embodiments, at least one light-diffusive layer may include plastics material, optionally selected out of polyethylene terephthalate - PET or polycarbonate - PC.

In one or more embodiments the electrically-powered light radiation sources may include solid-state light radiation sources, optionally LED sources.

One or more embodiments may include a method of manufacturing a lighting device, the method including laminating together (e.g. L)the layers in the stacked arrangement of layers according to one or more embodiments.

Without prejudice to the underlying principles, the details and embodiments may vary, even significantly, with respect to what has been described by way of example only, without departing from the extent of protection.

The extent of protection is defined by the annexed claims.

### LIST OF REFERENCE SIGNS

- Lighting device: 10
- Light-emitting layer: 100
- Light radiation sources: 100a
- Light-diffusive layer: 106a
- Light-diffusive layer: 106b
- Adhesive layer: 108
- Cover layer: 110
- Support substrate: 104
- Lamination: L
- Cutting: S

## Claims

1. A lighting device (10) including a stacked arrangement of layers, including:
- a light-emitting layer (100) with a distribution of electrically-powered light radiation sources (100a), and
- at least one light-diffusive layer (106a, 106b) laminated over the light-emitting layer (100) to diffuse light radiation from the light radiation sources (100a).

2. The lighting device (10) of claim 1, including a light-permeable adhesive layer (108) between the light-emitting layer (100) and the at least one light-diffusive layer (106a).

3. The lighting device (10) of claim 1 or claim 2, including a light-permeable cover layer (110) with the at least one light-diffusive layer (106a) sandwiched between the light-emitting layer (100) and the light-permeable cover layer (110).

4. The lighting device (10) of any of the previous claims, including a plurality of light-diffusive layers (106a, 106b) laminated over the light-emitting layer (100) to diffuse light radiation from the light radiation sources (100a).

5. The lighting device (10) of claim 3 and claim 4, including said cover layer (110) sandwiched between two light-diffusive layers (106a, 106b) in the plurality of light-diffusive layers.

6. The lighting device (10) of any of the previous claims, including a support substrate (104) coupled to the light-emitting layer (100).

7. The lighting device (10) of claim 6, including the support substrate (104) coupled to the light-emitting layer (100) opposite the at least one light-diffusive layer (106a, 106b).

8. The lighting device (10) of any of the previous claims, wherein the at least one light-diffusive layer (106a, 106b) includes plastic material, preferably selected out of polyethylene terephthalate - PET or polycarbonate - PC.

9. The lighting device (10) of any of previous claims, wherein the electrically-powered light radiation sources (100a) include solid-state light radiation sources, preferably LED sources.

10. A method of manufacturing a lighting device (10), the method including laminating together (L) the layers in the stacked arrangement of layers as called for in any of the previous claims.
